# EUROPÄISCHE PATENTSCHRIFT

(11) **EP 4 476 762 B1**
(45) Veröffentlichungstag und Bekanntmachung des Hinweises auf die Patenterteilung: **19.11.2025**
(21) Anmeldenummer: 23716405.8
(22) Anmeldetag: 23.03.2023
(51) Int. Cl.: H01L 21/48, H01L 23/367, H01L 23/373

(54) **VERFAHREN ZUM HERSTELLEN EINES KÜHLKÖRPERS MIT FINNEN UND EINER UMLAUFENDEN SEITENWAND**
METHOD OF MANUFACTURING A HEAT SINK WITH FINS AND A CIRCUMFERENTIAL SIDEWALL
PROCÉDÉ DE FABRICATION D'UN CORPS DISSIPATEUR À AILETTES ET D'UNE PAROI LATÉRALE TOURNANTE

(30) Priorität: 05.05.2022 EP 22171735
(43) Veröffentlichungstag der Anmeldung: 18.12.2024
(73) Patentinhaber: Siemens Aktiengesellschaft, 80333 München (DE)
(72) Erfinder: MÜNZINGER, Marius, 90459 Nürnberg (DE); NÖTH, Christoph, 90542 Eckental (DE)
(74) Vertreter: Siemens Patent Attorneys
(86) Internationale Anmeldenummer: PCT/EP2023/057401
(87) Internationale Veröffentlichungsnummer: WO 2023/213471

(56) Entgegenhaltungen:
- EP-A1- 3 466 559
- WO-A1-2021/058212
- DE-A1- 10 014 458
- DE-A1- 102007 061 599
- DE-A1- 102019 001 383
- JP-A- 2015 050 318
- JP-A- S5 112 370

## Beschreibung

Die Erfindung betrifft ein Verfahren zum Herstellen eines Kühlkörpers mit Finnen und einer umlaufenden Seitenwand durch Fließpressen.

Ferner betrifft die Erfindung einen Kühlkörper für eine Halbleiteranordnung, welcher durch ein derartiges Fließpressverfahren hergestellt ist.

Überdies betrifft die Erfindung eine Halbleiteranordnung mit mindestens einem Halbleiterelement und einem Kühlkörper.

Darüber hinaus betrifft die Erfindung einen Stromrichter mit mindestens einer Halbleiteranordnung.

In derartigen Stromrichtern werden in der Regel Halbleiteranordnungen auf einen Kühlkörper befestigt. Unter einem Stromrichter ist beispielsweise ein Gleichrichter, ein Wechselrichter, ein Umrichter oder ein Gleichspannungswandler zu verstehen. Üblicherweise sind die Halbleiteranordnungen als Elektronikmodule ausgeführt, die ein Gehäuse aufweisen und über eine massive metallische Bodenplatte auf den Kühlkörper aufgeschraubt sind. Ferner können die Halbleiteranordnungen unmittelbar mit dem Kühlkörper verbunden werden. Die Halbleiteranordnungen können unter anderem Insulated-Gate-BipolarTransistoren (IGBTs) und/oder Metall-Oxid-Halbleiter-Feldeffekttransistoren (MOSFETs) umfassen.

Die Offenlegungsschrift EP 3 933 913 A1 beschreibt ein Leistungsmodul mit mindestens zwei Leistungseinheiten, welche jeweils mindestens einen Leistungshalbleiter und ein Substrat umfassen. Um den erforderlichen Bauraum des Leistungsmoduls zu verringern und eine Entwärmung zu verbessern, wird vorgeschlagen, dass der jeweils mindestens eine Leistungshalbleiter, insbesondere stoffschlüssig, mit dem jeweiligen Substrat verbunden ist, wobei die Substrate der mindestens zwei Leistungseinheiten jeweils unmittelbar stoffschlüssig mit einer Oberfläche eines gemeinsamen Kühlkörpers verbunden sind.

Die JP S51 12370 A beschreibt Verfahren zur Herstellung eines Kühlers zur Entwärmung eines Halbleiters, wobei eine Gruppe von stiftförmigen Kühlelementen durch Kaltextrusion eines Materials mit einem Stempel und einer mit einer Anzahl von Löchern versehenen Matrize einstückig auf einem Substrat ausgebildet wird.

Die Offenlegungsschrift DE 100 14 458 A1 beschreibt einen Kühlkörper mit einem Grundkörper und einem Zwischenelement zur Aufnahme eines elektronischen Bauelementes oder einer elektronischen Schaltung. Gemäß der Offenbarung wird vorgeschlagen, daß das Zwischenelement durch Umform- oder Urformverfahren zumindest teilweise in den Kühlkörper eingebracht worden ist. Hierdurch wird ein inniger Kontakt zwischen dem Zwischenelement und dem Grundkörper bewirkt, so daß die Wärmeableitung verbessert werden kann.

Um die hohen Isolationsanforderungen bei solchen Elektronikmodulen zu erfüllen, werden die Halbleiter und Verbindungsmittel, z.B. Bonddrähte, mit einer Vergussmasse bedeckt. Die Vergussmasse verhindert zusätzlich das Eindringen von Feuchtigkeit und eine Korrosion der Bauteile.

Die Offenlegungsschrift WO 2021/058212 A1 beschreibt einen Träger für wenigstens ein elektrisches Bauelement. Der Träger umfasst einen Kühlkörper mit einer Kühlkörperoberfläche und zwei von der Kühlkörperoberfläche abstehenden, sich gegenüberliegenden Seitenwänden, zwei auf der Kühlkörperoberfläche aufliegende, voneinander beabstandete Abdichtblöcke, die sich jeweils zwischen den beiden Seitenwänden erstrecken und an jeder der beiden Seitenwände anliegen, und eine auf der Kühlkörperoberfläche zwischen den beiden Abdichtblöcken angeordnete Trägerstruktur für das wenigstens eine elektrische Bauelement.

Vor diesem Hintergrund ist es eine Aufgabe der vorliegenden Erfindung, ein kostengünstiges Verfahren zur Herstellung eines Kühlkörpers anzugeben.

Die Aufgabe wird erfindungsgemäß gelöst durch ein Verfahren zum Herstellen eines Kühlkörpers mit Finnen und einer umlaufenden Seitenwand durch Fließpressen umfassend folgende Schritte: Bereitstellen einer Matrize, welche eine Grundfläche aufweist, und eines Stempels, welcher eine Druckfläche aufweist, wobei die Grundfläche der Matrize Öffnungen aufweist, wobei auf der Druckfläche des Stempels ein umlaufender Falz ausgebildet ist, Einlegen eines Halbzeugs aus einem ersten metallischen Werkstoff in die Matrize, lösbares Verbinden einer Materiallage aus einem zweiten metallischen Werkstoff, welcher eine höhere Wärmeleitfähigkeit als der erste metallische Werkstoff aufweist, mit der Druckfläche des Stempels, Kontaktieren des Stempels über die Materiallage mit dem in der Matrize eingelegten Halbzeug, Pressen des ersten metallischen Werkstoffs des Halbzeugs mittels des Stempels durch die Öffnungen der Matrize zur Ausbildung der Finnen und in den umlaufenden Falz des Stempels zur Ausbildung der umlaufenden Seitenwand, wobei die Materiallage vollflächig mit dem ersten metallischen Werkstoff des Halbzeugs verbunden wird, wobei durch das Pressen der Kühlkörper ausgebildet wird, Lösen des Stempels von der Materiallage, Ausstoßen des Kühlkörpers aus der der Matrize.

Ferner wird die Aufgabe erfindungsgemäß durch einen Kühlkörper für eine Halbleiteranordnung, welcher durch ein derartiges Fließpressverfahren hergestellt ist, aufweisend Finnen, welche durch Pressen des Halbzeugs mittels einer Druckfläche des Stempels durch Öffnungen der Matrize hergestellt sind, eine umlaufende Seitenwand, welche auf einer den Finnen gegenüberliegenden Seite des Kühlkörpers angeordnet sind ist und durch Pressen des Halbzeugs in einen umlaufenden Falz des Stempels hergestellt ist, eine ebene Fläche innerhalb der umlaufende Seitenwand, welche durch die Druckfläche des Stempels ausgebildet ist und die Materiallage aus dem zweiten metallischen Werkstoff umfasst.

Überdies wird die Aufgabe erfindungsgemäß durch eine Halbleiteranordnung mit mindestens einem Halbleiterelement und einem derartigen Kühlkörper gelöst, wobei das Halbleiterelement elektrisch isolierend und thermisch leitend mit dem Kühlkörper verbunden ist.

Darüber hinaus wird die Aufgabe erfindungsgemäß durch einen Stromrichter mit mindestens einer derartigen Halbleiteranordnung gelöst.

Die in Bezug auf das Verfahren nachstehend angeführten Vorteile und bevorzugten Ausgestaltungen lassen sich sinngemäß auf den Kühlkörper, die Halbleiteranordnung und den Stromrichter übertragen.

Der Erfindung liegt die Überlegung zugrunde, einen Kühlkörper mit einer umlaufenden Seitenwand, Finnen und einer Wärmespreizfläche durch Fließpressen herzustellen, um eine verbesserte Kostenposition zu erreichen. Der Kühlkörper wird mittels eines Halbzeugs aus einem ersten metallischen Werkstoff hergestellt. Beispielsweise ist der erste metallische Werkstoff eine Aluminiumlegierung, insbesondere eine Aluminiumknetlegierung. Die Wärmespreizfläche wird mittels einer Materiallage aus einem zweiten metallischen Werkstoff, welcher eine höhere Wärmeleitfähigkeit als der erste metallische Werkstoff aufweist, hergestellt. Der zweite metallische Werkstoff ist beispielsweise Kupfer oder eine Kupferlegierung. Beispielsweise ist die Materiallage als Kupferblech ausgeführt.

Das Fließpressverfahren wird mittels einer Matrize, welche eine Grundfläche aufweist, und eines Stempels, welcher eine Druckfläche aufweist, durchgeführt. Die Grundfläche der Matrize kann unter anderem, abhängig von der gewünschten Form des Kühlkörpers, rechteckig, insbesondere quadratisch, oder elliptisch, insbesondere kreisförmig, ausgeführt sein und weist Öffnungen auf. Die Öffnungen können, unter anderem, rechteckig, insbesondere quadratisch, oder elliptisch, insbesondere kreisförmig, ausgeführt sein. Auf der Druckfläche des Stempels ist ein umlaufender Falz ausgebildet, welcher beispielsweise mittels eines spanenden Verfahrens, insbesondere durch Fräsen, hergestellt wird. Der Falz ist beispielsweise als Stufenfalz mit einer rechteckigen oder trapezförmigen Profilierung ausgeführt.

Die Materiallage wird lösbar auf der Druckfläche des Stempels. Die lösbare Verbindung kann beispielsweise adhäsiv mittels eines lösbaren Klebstoffs erfolgen. Eine lösbare adhäsive Verbindung der Materiallage verhindert vorteilhaft eine Verschiebung während des Pressvorgangs. Nach dem Einlegen des Halbzeugs aus einem ersten metallischen Werkstoff in die Matrize wird der Stempel über die Materiallage mit dem in der Matrize eingelegten Halbzeug kontaktiert. Daraufhin wird der erste metallischen Werkstoff des Halbzeugs mittels des Stempels durch die Öffnungen der Matrize zur Ausbildung der Finnen und in den umlaufenden Falz des Stempels zur Ausbildung der umlaufenden Seitenwand gepresst, wobei die Materiallage vollflächig mit dem ersten metallischen Werkstoff des Halbzeugs zur Ausbildung der Wärmespreizfläche verbunden wird. Durch den Pressvorgang wird der Kühlkörper ausgebildet. Das Verfahren erfolgt beispielsweise mittels Napf-Fließpressen, insbesondere mittels Napf-Vorwärts-Fließpressen. In einem weiteren Schritt wird der Stempel von der Materiallage gelöst und der Kühlkörper aus der der Matrize ausgestoßen. Nach dem Fließpressen sind keine weiteren Schritte, wie beispielsweise ein Verbinden der Materiallage zur Wärmespreizung, erforderlich, sodass sich auch für kleinere Stückzahlen Kosten einsparen lassen.

Eine weitere Ausführungsform sieht vor, dass nach dem Pressen ein, insbesondere bündiges, Ablängen der Finnen in der Matrize erfolgt. Unmittelbar nach dem Fließpressen können die Finnen unterschiedliche Längen aufweisen und/oder unregelmäßig aus den Öffnungen der Matrize herausstehen. Durch das Ablängen werden die Finnen kostengünstig, beispielsweise mittels einer Säge- Fräs- und/oder Schneidevorrichtung, auf eine einheitliche Endlänge gekürzt.

Eine weitere Ausführungsform sieht vor, dass die Materiallage derartig lösbar mit dem Stempel verbunden wird, dass die Materiallage bündig mit der Druckfläche des Stempels abschließt. Durch eine derartige Anordnung ist kostengünstig eine maximal große Wärmespreizfläche herstellbar.

Eine weitere Ausführungsform sieht vor, dass die Materiallage über eine Pressschweißverbindung stoffschlüssig mit dem ersten metallischen Werkstoff verbunden wird. Eine derartige Verbindung ist robust und kostengünstig herzustellen. Ferner wird der thermische Widerstand zwischen dem zweiten metallischen Werkstoff der Materiallage und dem ersten metallischen Werkstoff, insbesondere im Vergleich zu einer Löt- oder Sinterverbindung, reduziert.

Eine weitere Ausführungsform sieht vor, dass die Materiallage auf einer der Druckfläche des Stempels abgewandten Seite aufgeraut wird. Eine derartige aufgeraute Oberfläche ist kostengünstig herstellbar und verbessert eine Verzahnung zwischen dem zweiten metallischen Werkstoff der Materiallage und dem ersten metallischen Werkstoff.

Eine weitere Ausführungsform sieht vor, dass die Materiallage über Mikroformschlüsse mit dem ersten metallischen Werkstoff verbunden wird. Insbesondere mit einer aufgerauten Oberfläche ist eine derartige Verbindung über Mikroformschlüsse robust und kostengünstig herstellbar.

Eine weitere Ausführungsform sieht vor, dass die Öffnungen der Matrize als Langlöcher ausgebildet sind, wobei der erste metallische Werkstoff des Halbzeugs durch die Langlöcher der Matrize zur Ausbildung von lamellenförmigen Finnen gepresst wird. Die Langlöcher können eckig oder abgerundet ausgeführt sein. Durch lamellenförmige Finnen ist, insbesondere bei einer seitlichen Kühlfluidströmung, eine optimale Entwärmung erzielbar.

Eine weitere Ausführungsform sieht vor, dass eine dielektrische Materiallage lösbar zwischen der Druckfläche des Stempels und der Materiallage aus dem zweiten metallischen Werkstoff verbunden wird, wobei die dielektrische Materiallage beim Pressen unlösbar mit der Materiallage verbunden wird. Die dielektrische Materiallage enthält beispielsweise einen organischen Isolator. Der organische Isolator kann unter anderem mit einem keramischen Werkstoff wie Aluminiumoxid und/oder Aluminiumnitrid gefüllt sein. Durch den Druck des Stempels wird die dielektrische Materiallage kostengünstig und einfach mit der Materiallage verpresst.

Eine weitere Ausführungsform sieht vor, dass die Matrize eine innere Mantelfläche und der Stempel eine äußere Mantelfläche aufweist, wobei die äußere Mantelfläche des Stempels beim Pressen parallel bündig zur inneren Mantelfläche der Matrize verlaufend bewegt wird. Dadurch wird eine Nachbearbeitung des Kühlkörpers vermieden, was zusätzliche Kosten einspart.

Eine weitere Ausführungsform sieht vor, dass für den ersten metallischen Werkstoff eine Aluminiumlegierung, insbesondere eine Aluminiumknetlegierung, verwendet wird. Eine derartige Legierung ist besonders gut formbar, sodass Finnen mit einem großen Verhältnis aus Länge und Abstand zueinander herstellbar sind, was zu einer verbesserten Kühlleistung führt.

Eine weitere Ausführungsform sieht vor, dass eine Aluminiumlegierung verwendet wird, welche Silizium mit einem Gewichtsanteil im Bereich von 0,1 % bis 1 %, insbesondere im Bereich von 0,1 % bis 0,5 %, enthält. Die Aluminiumlegierung kann unter anderem EN AW 6060 (AlMgSi0,5) sein. Bei einem durch Fließpressen hergestellten Kühlkörper ist, insbesondere im Vergleich zu einem gegossenen Kühlkörper, ein derartig niedriger Siliziumanteil der Aluminiumlegierung verwendbar, welcher zu einer verbesserten Wärmeleitfähigkeit führt.

Im Folgenden wird die Erfindung anhand der in den Figuren dargestellten Ausführungsbeispiele näher beschrieben und erläutert.

Es zeigen:
- FIG 1: eine schematische dreidimensionale Schnittdarstellung eines Verfahrens zum Herstellen eines Kühlkörpers,
- FIG 2: eine schematische dreidimensionale Schnittdarstellung eines weiteren Verfahrensschritt zum Herstellen eines Kühlkörpers,
- FIG 3: eine schematische dreidimensionale Darstellung eines Kühlkörpers mit zylinderförmigen Finnen,
- FIG 4: eine schematische Schnittdarstellung von weiteren Verfahrensschritten zum Herstellen eines Kühlkörpers,
- FIG 5: eine schematische Schnittdarstellung eines Kühlkörpers mit einer dielektrische Materiallage,
- FIG 6: eine schematische Darstellung einer Matrize mit als rechteckige Langlöcher ausgeführten Öffnungen in einer Draufsicht,
- FIG 7: eine schematische Darstellung einer Matrize mit als abgerundete Langlöcher ausgeführten Öffnungen in einer Draufsicht,
- FIG 8: eine schematische dreidimensionale Darstellung eines Kühlkörpers mit lamellenförmigen Finnen,
- FIG 9: eine schematische Schnittdarstellung einer Halbleiteranordnung mit einem Kühlkörper und
- FIG 10: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

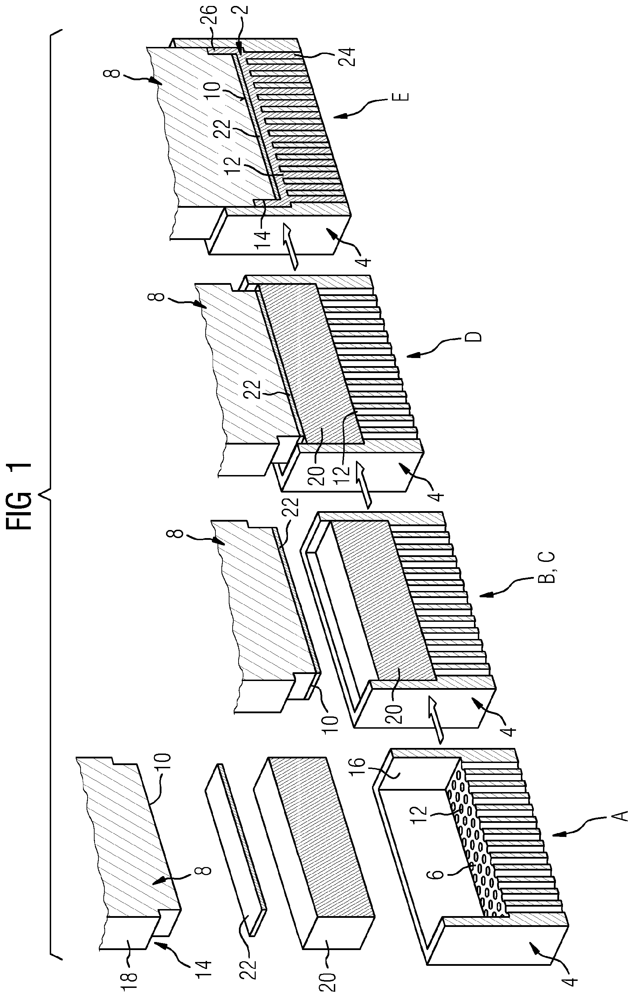

FIG 1 eine schematische dreidimensionale Schnittdarstellung eines Verfahrens zum Herstellen eines Kühlkörpers 2 durch Fließpressen. Der Kühlkörper 2 wird durch ein Vorwärts-Fließpressverfahren, insbesondere durch ein Napf-Vorwärts-Fließpressverfahren, hergestellt. Das Verfahren umfasst ein Bereitstellen A einer Matrize 4, welche eine Grundfläche 6 aufweist, und eines Stempels 8, welcher eine Druckfläche 10 aufweist. Die Grundfläche 6 der Matrize 4 weist beispielhaft runde Öffnungen 12 zur Ausbildung zylinderförmiger Kühlfinnen auf. Auf der Druckfläche 10 des Stempels 8 ist ein umlaufender Falz 14, insbesondere Stufenfalz, ausgebildet. Ferner weist die Matrize 4 eine innere Mantelfläche 16 und der Stempel 8 eine äußere Mantelfläche 18 auf, wobei die die äußere Mantelfläche 18 des Stempels 8 derartig dimensioniert ist, dass diese parallel bündig zur inneren Mantelfläche 16 der Matrize 4 verlaufend bewegbar ist. Ferner werden ein Halbzeug 20 aus einem ersten metallischen Werkstoff und eine Materiallage 22 aus einem zweiten metallischen Werkstoff bereitgestellt. Der zweite metallische Werkstoff weist eine höhere Wärmeleitfähigkeit als der erste metallische Werkstoff auf. Beispielsweise ist der erste metallische Werkstoff eine Aluminiumlegierung, insbesondere eine Aluminiumknetlegierung, welche Silizium mit einem Gewichtsanteil von weniger als 1 %, insbesondere weniger als 0,5 %, aufweist. Der erste metallische Werkstoff kann unter anderem EN AW 6060 (AlMgSi0,5) sein. Der zweite metallische Werkstoff ist beispielsweise Kupfer oder eine Kupferlegierung. Beispielsweise ist die Materiallage 22 als Kupferblech ausgeführt.

In einem weiteren Schritt erfolgt ein Einlegen B des Halbzeugs 20 aus dem ersten metallischen Werkstoff in die Matrize 4. Das Halbzeug 20 ist beispielhaft quaderförmig ausgeführt und an die innere Mantelfläche 16 der Matrize 4 angepasst. Darüber hinaus erfolgt ein lösbares Verbinden C der Materiallage 22 aus dem zweiten metallischen Werkstoff mit der Druckfläche 10 des Stempels 8. Die lösbare Verbindung kann beispielsweise adhäsiv mittels eines lösbaren Klebstoffs erfolgen. Alternativ kann die Materiallage 22 lösbar mit dem Halbzeug 20 verbunden werden. Ein lösbares Verbinden der Materiallage 22 mit dem Halbzeug 20 kann ferner ein Auflegen der Materiallage 22 auf eine, insbesondere ebene, Oberfläche des quaderförmig ausgeführten Halbzeugs 20 einschließen. Eine lösbare adhäsive Verbindung der Materiallage 22 verhindert eine Verschiebung während des Pressvorgangs.

In einem weiteren Schritt erfolgt ein Kontaktieren D des Stempels 8 über die Materiallage 22 mit dem in der Matrize 4 eingelegten Halbzeug 20. Insbesondere wird die Materiallage 22 vollflächig mit der Oberfläche des quaderförmig ausgeführten Halbzeugs 20 kontaktiert.

Daraufhin erfolgt ein Pressen E des Halbzeugs 20 mittels des Stempels 8 zur Ausbildung des Kühlkörpers 2. Der erste metallische Werkstoff des Halbzeugs 20 wird durch die Öffnungen 12 der Matrize 4 zur Ausbildung der Finnen 24 und in den umlaufenden Falz 14 des Stempels 6 zur Ausbildung der umlaufenden Seitenwand 26 gepresst. Die Materiallage 22 ist auf einer der Druckfläche 10 des Stempels 8 abgewandten Seite aufgeraut. Durch den mittels des Pressvorgangs erzeugten Druck wird die aufgeraute Materiallage 22 vollflächig über Mikroformschlüsse mit dem ersten metallischen Werkstoff verbunden. Zusätzlich oder alternativ erfolgt die Verbindung stoffschlüssig mittels Pressschweißen.

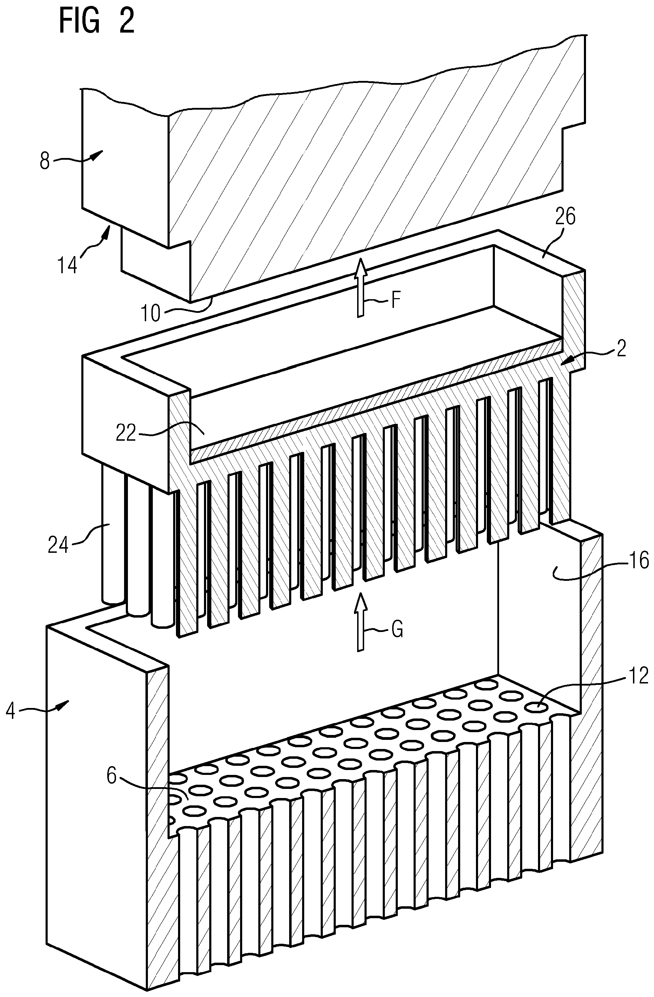

FIG 2 zeigt eine schematische dreidimensionale Schnittdarstellung eines weiteren Verfahrensschritt zum Herstellen eines Kühlkörpers 2, welcher ein Lösen F des Stempels 8 von der Materiallage 22 und ein Ausstoßen F des Kühlkörpers 2 aus der der Matrize 4 beinhaltet. Ausstoßmittel sind aus Gründen der Übersichtlichkeit in FIG 2 nicht dargestellt. Die weitere Ausgestaltung des Verfahrens in FIG 2 entspricht dem in FIG 1.

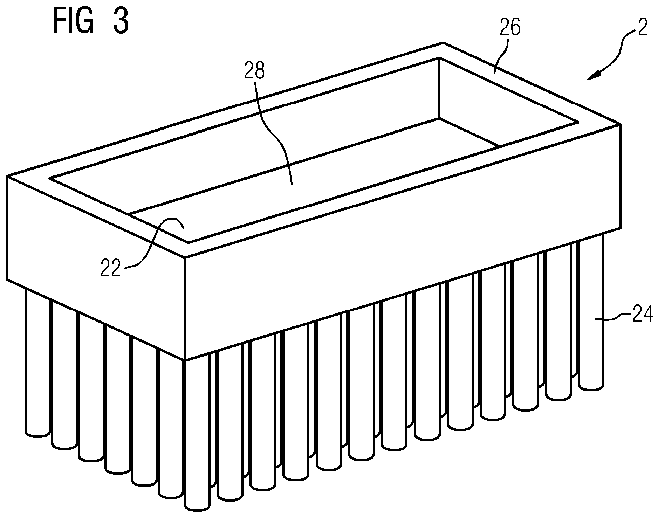

FIG 3 zeigt eine schematische dreidimensionale Darstellung eines Kühlkörpers 2 mit zylinderförmigen Finnen 24. Die Materiallage 22 enthält Kupfer und bildet eine, beispielhaft rechteckige, ebene Kontaktfläche 28 zur, insbesondere flächigen, Kontaktierung von elektronischen Bauelementen wie Leistungshalbleiter aus. Durch die Materiallage 22 wird während des Betriebes eines elektronischen Bauelements eine Wärmespreizung erzielt. Die weitere Ausgestaltung des Kühlkörpers 2 in FIG 3 entspricht der in FIG 2.

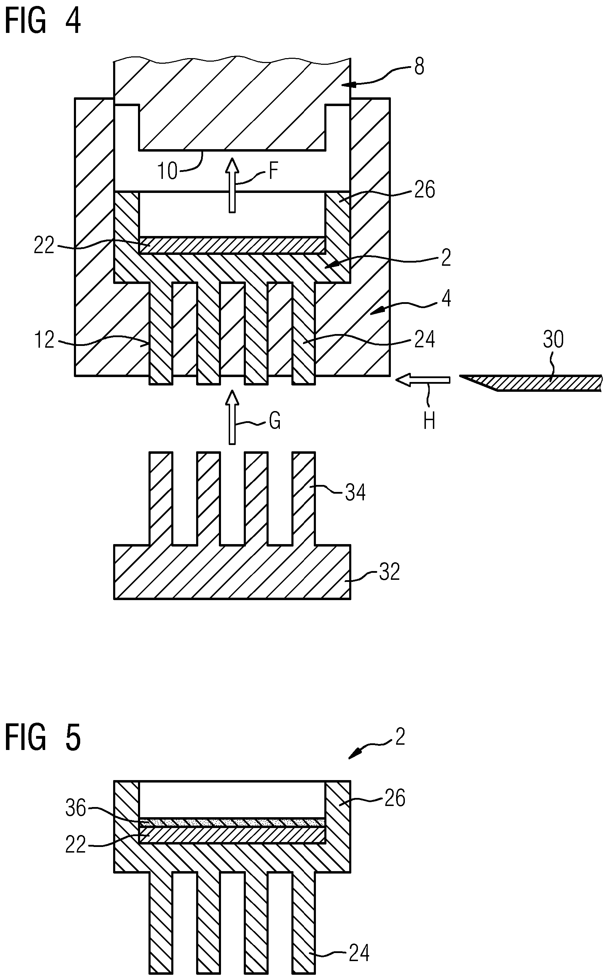

FIG 4 zeigt eine schematische Schnittdarstellung von weiteren Verfahrensschritten zum Herstellen eines Kühlkörpers 2. Nach dem Pressen E, welches in FIG 1 gezeigt ist, erfolgt ein Ablängen H der Finnen 24 in der Matrize 4. Beispielsweise werden die Finnen 24 durch Ablängmittel 30 auf eine einheitliche Endlänge gekürzt. Die Ablängmittel 30 können eine Säge- Fräs- und/oder Schneidevorrichtung umfassen. Daraufhin erfolgt ein Lösen F des Stempels 8 von der Materiallage 22 und ein Ausstoßen G des Kühlkörpers 2 aus der der Matrize 4 durch Ausstoßmittel 32, welche zu den Finnen 24 korrespondierende Auswerferzapfen 34 umfassen. Die weitere Ausgestaltung des Verfahrens in FIG 4 entspricht dem in FIG 1.

FIG 5 zeigt eine schematische Schnittdarstellung eines Kühlkörpers 2 mit einer dielektrische Materiallage 36, welche beispielsweise einen organischen Isolator enthält. Der organische Isolator kann unter anderem mit einem keramischen Werkstoff wie Aluminiumoxid und/oder Aluminiumnitrid gefüllt sein. Die dielektrische Materiallage 36 wird bei der Herstellung des Kühlkörpers 2 lösbar zwischen der Druckfläche 10 des Stempels 8 und der Materiallage 22 verbunden. Beim Pressen (E) wird die dielektrische Materiallage 36 daraufhin mit der Materiallage 22 verpresst. Darüber hinaus weist der Kühlkörper 2 lamellenförmige Finnen 24 auf. Die weitere Ausgestaltung des Kühlkörpers 2 in FIG 3 entspricht der in FIG 3.

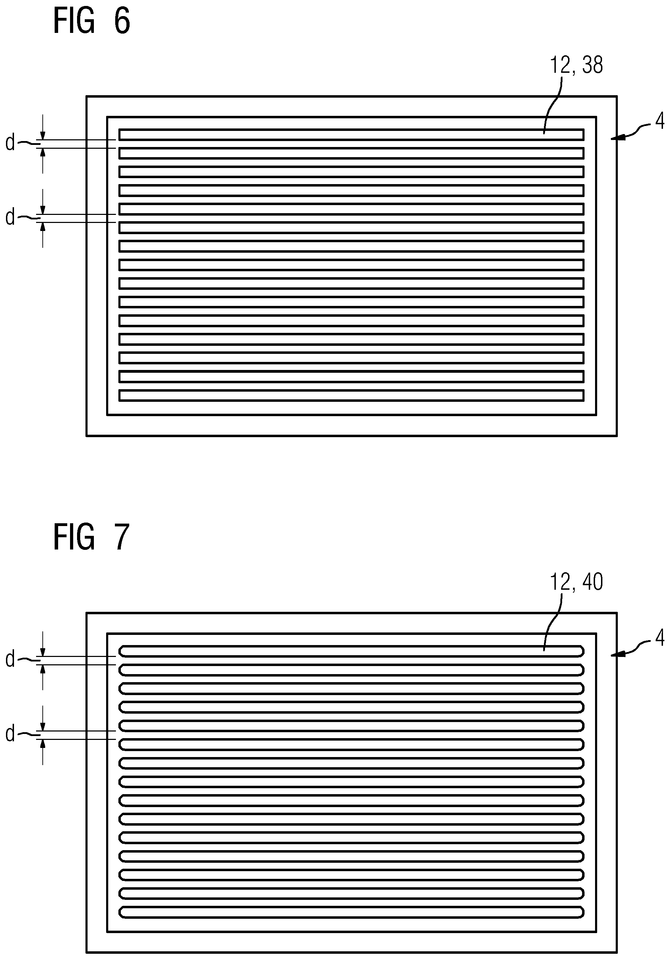

FIG 6 zeigt eine schematische Darstellung einer Matrize 4 mit als rechteckige Langlöcher 38 ausgeführten Öffnungen 12 in einer Draufsicht. Durch derartige Langlöcher 38 sind lamellenförmige Finnen herstellbar. Die rechteckigen Langlöcher 38 sind parallel verlaufend angeordnet und weisen identische Abstände d auf. Um einen fokussierte Entwärmung, insbesondere zur Vermeidung von Hot-Spots, zu erzielen, können die Abstände d variiert werden. Die weitere Ausgestaltung der Öffnungen 12 in FIG 6 entspricht der in FIG 1.

FIG 7 zeigt eine schematische Darstellung einer Matrize 4 mit als abgerundete Langlöcher 40 ausgeführten Öffnungen 12 in einer Draufsicht. Beispielhaft sind die Öffnungen 12 als halbkreisförmig abgerundete Langlöcher 40 ausgeführt. Die weitere Ausgestaltung der Öffnungen 12 in FIG 7 entspricht der in FIG 6.

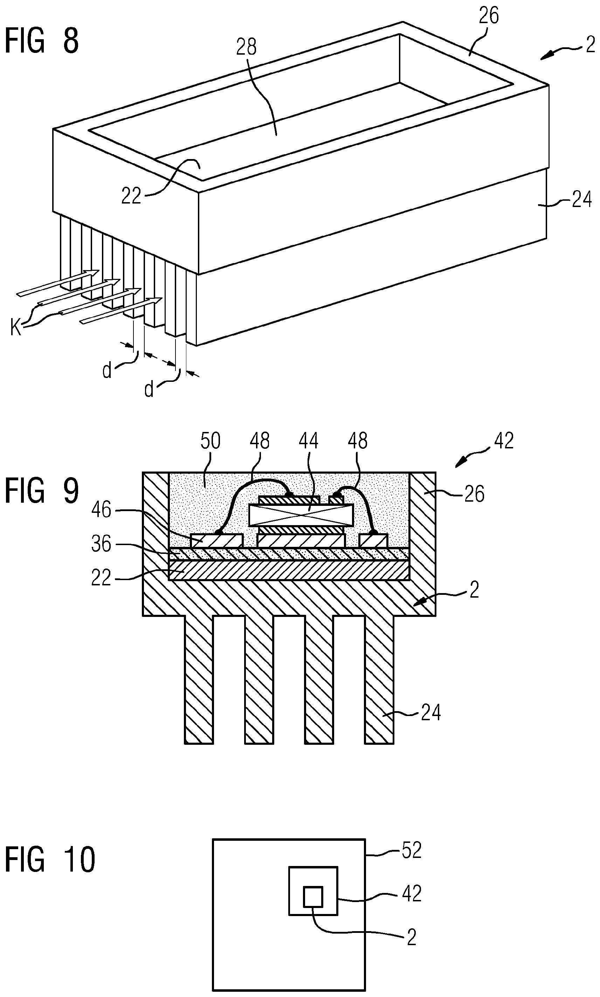

FIG 8 zeigt eine schematische dreidimensionale Darstellung eines Kühlkörpers 2 mit lamellenförmigen Finnen 24, welche parallel verlaufend angeordnet sind und identische Abstände d aufweisen. Insbesondere ist der Kühlkörpers 2 mit einer Matrize 4, welche wie in FIG 6 ausgeführt ist, hergestellt. Eine Kühlfluidströmung K verläuft entlang der parallelen lamellenförmigen Finnen 24. Die weitere Ausgestaltung des Kühlkörpers 2 in FIG 8 entspricht der in FIG 3.

FIG 9 zeigt eine schematische Schnittdarstellung einer Halbleiteranordnung 42 mit einem Kühlkörper 2. Die Halbleiteranordnung 42 umfasst beispielhaft ein Halbleiterelement 44, das als vertikaler Leistungstransistor, insbesondere als Insulated-Gate-Bipolar-Transistor (IGBT), ausgeführt ist. Der IGBT ist, insbesondere stoffschlüssig, mit einer strukturierten Metallisierung 46 verbunden, die über die dielektrische Materiallage 36 elektrisch isolierend und thermisch leitfähig mit dem Kühlkörper 2 verbunden ist. Beispielsweise ist der IGBT kollektorseitig mit der Metallisierung 46 stoffschlüssig verbunden. Die stoffschlüssige Verbindung kann unter anderem eine Lötverbindung und/oder eine Sinterverbindung aber auch eine adhäsive Verbindung, z.B. mit einem elektrisch und thermisch leitfähigen Kleber, sein. Ferner ist der IGBT gate- und emitterseitig über Bondverbindungen 48, insbesondere über Bonddrähte oder Bondbänder, mit der Metallisierung 46 verbunden. Das Halbleiterelement 44 ist durch eine Vergussmasse 50 vollständig vergossen, wobei die Vergussmasse 50 durch die umlaufende Seitenwand 26 des Kühlkörpers 2 begrenzt wird. Die Vergussmasse 50 enthält beispielsweise einen Weichverguss, insbesondere ein Silikonverguss. Die weitere Ausgestaltung des Kühlkörpers 2 in FIG 9 entspricht der in FIG 8.

FIG 10 zeigt eine schematische Darstellung eines Stromrichters 52, welcher beispielhaft eine Halbleiteranordnung 42 mit einem Kühlkörper 2 umfasst. Die Halbleiteranordnung 42 in FIG 10 ist wie in FIG 9 dargestellt ausgeführt.

Zusammenfassend betrifft die Erfindung ein Verfahren zum Herstellen eines Kühlkörpers 2 mit Finnen 24 und einer umlaufenden Seitenwand 26 durch Fließpressen. Um Kosten einzusparen, werden folgende Schritte vorgeschlagen: Bereitstellen A einer Matrize 4, welche eine Grundfläche 6 aufweist, und eines Stempels 8, welcher eine Druckfläche 10 aufweist, wobei die Grundfläche 6 der Matrize 4 Öffnungen 12 aufweist, wobei auf der Druckfläche 10 des Stempels 8 ein umlaufender Falz 14 ausgebildet ist, Einlegen B eines Halbzeugs 20 aus einem ersten metallischen Werkstoff in die Matrize 4, lösbares Verbinden C einer Materiallage 22 aus einem zweiten metallischen Werkstoff, welcher eine höhere Wärmeleitfähigkeit als der erste metallische Werkstoff aufweist, mit der Druckfläche 10 des Stempels 8, Kontaktieren D des Stempels 8 über die Materiallage 22 mit dem in der Matrize 4 eingelegten Halbzeug 20, Pressen E des ersten metallischen Werkstoffs des Halbzeugs 20 mittels des Stempels 8 durch die Öffnungen 12 der Matrize 4 zur Ausbildung der Finnen 24 und in den umlaufenden Falz 14 des Stempels 8 zur Ausbildung der umlaufenden Seitenwand 26, wobei die Materiallage 22 vollflächig mit dem ersten metallischen Werkstoff des Halbzeugs 20 verbunden wird, wobei durch das Pressen E der Kühlkörper 2 ausgebildet wird, Lösen F des Stempels 8 von der Materiallage 22, Ausstoßen G des Kühlkörpers 2 aus der der Matrize 4.

## Patentansprüche

1. Verfahren zum Herstellen eines Kühlkörpers (2) mit Finnen (24) und einer umlaufenden Seitenwand (26) durch Fließpressen umfassend folgende Schritte:
- Bereitstellen (A) einer Matrize (4), welche eine Grundfläche (6) aufweist, und eines Stempels (8), welcher eine Druckfläche (10) aufweist, wobei die Grundfläche (6) der Matrize (4) Öffnungen (12) aufweist, wobei auf der Druckfläche (10) des Stempels (8) ein umlaufender Falz (14) ausgebildet ist,
- Einlegen (B) eines Halbzeugs (20) aus einem ersten metallischen Werkstoff in die Matrize (4),
- lösbares Verbinden (C) einer Materiallage (22) aus einem zweiten metallischen Werkstoff, welcher eine höhere Wärmeleitfähigkeit als der erste metallische Werkstoff aufweist, mit der Druckfläche (10) des Stempels (8),
- Kontaktieren (D) des Stempels (8) über die Materiallage (22) mit dem in der Matrize (4) eingelegten Halbzeug (20),
- Pressen (E) des ersten metallischen Werkstoffs des Halbzeugs (20) mittels des Stempels (8) durch die Öffnungen (12) der Matrize (4) zur Ausbildung der Finnen (24) und in den umlaufenden Falz (14) des Stempels (8) zur Ausbildung der umlaufenden Seitenwand (26), wobei die Materiallage (22) vollflächig mit dem ersten metallischen Werkstoff des Halbzeugs (20) verbunden wird, wobei durch das Pressen (E) der Kühlkörper (2) ausgebildet wird,
- Lösen (F) des Stempels (8) von der Materiallage (22),
- Ausstoßen (G) des Kühlkörpers (2) aus der der Matrize (4).

2. Verfahren nach Anspruch 1,
wobei nach dem Pressen (E) ein, insbesondere bündiges, Ablängen (H) der Finnen (24) in der Matrize (4) erfolgt.

3. Verfahren nach einem der Ansprüche 1 oder 2,
wobei die Materiallage (22) derartig lösbar mit dem Stempel (8) verbunden wird, dass die Materiallage (22) bündig mit der Druckfläche (10) des Stempels (8) abschließt.

4. Verfahren nach einem der vorherigen Ansprüche,
wobei die Materiallage (22) über eine Pressschweißverbindung stoffschlüssig mit dem ersten metallischen Werkstoff verbunden wird.

5. Verfahren nach einem der vorherigen Ansprüche,
wobei die Materiallage (22) auf einer der Druckfläche (10) des Stempels (8) abgewandten Seite aufgeraut wird.

6. Verfahren nach Anspruch 5,
wobei die Materiallage (22) über Mikroformschlüsse mit dem ersten metallischen Werkstoff verbunden wird.

7. Verfahren nach einem der vorherigen Ansprüche,
wobei die Öffnungen (12) der Matrize (4) als Langlöcher (38, 40) ausgebildet sind,
wobei der erste metallische Werkstoff des Halbzeugs (20) durch die Langlöcher (38, 40) der Matrize (4) zur Ausbildung von lamellenförmigen Finnen (24) gepresst wird.

8. Verfahren nach einem der vorherigen Ansprüche,
wobei eine dielektrische Materiallage (36) lösbar zwischen der Druckfläche (10) des Stempels (8) und der Materiallage (22) aus dem zweiten metallischen Werkstoff verbunden wird,
wobei die dielektrische Materiallage (36) beim Pressen (E) unlösbar mit der Materiallage (22) verbunden wird.

9. Verfahren nach einem der vorherigen Ansprüche,
wobei die Matrize (4) eine innere Mantelfläche (16) und der Stempel (8) eine äußere Mantelfläche (18) aufweist,
wobei die äußere Mantelfläche (18) des Stempels (8) beim Pressen (E) parallel bündig zur inneren Mantelfläche (16) der Matrize (4) verlaufend bewegt wird.

10. Verfahren nach einem der vorherigen Ansprüche,
wobei für den ersten metallischen Werkstoff eine Aluminiumlegierung, insbesondere eine Aluminiumknetlegierung, verwendet wird.

11. Verfahren nach Anspruch 10,
wobei eine Aluminiumlegierung verwendet wird, welche Silizium mit einem Gewichtsanteil im Bereich von 0,1 % bis 1 %, insbesondere im Bereich von 0,1 % bis 0,5 %, enthält.

12. Kühlkörper (2) für eine Halbleiteranordnung (42), welcher durch ein Fließpressverfahren nach einem der vorherigen Ansprüche hergestellt ist, aufweisend
- Finnen (24),
welche durch Pressen (E) des Halbzeugs (20) mittels einer Druckfläche (10) des Stempels (8) durch Öffnungen (12) der Matrize (4) hergestellt sind,
- eine umlaufende Seitenwand (26),
welche auf einer den Finnen (24) gegenüberliegenden Seite des Kühlkörpers (2) angeordnet sind ist und
durch Pressen (E) des Halbzeugs (20) in einen umlaufenden Falz (14) des Stempels (8) hergestellt ist,
- eine ebene Fläche innerhalb der umlaufende Seitenwand (26),
welche durch die Druckfläche (10) des Stempels (8) ausgebildet ist und die Materiallage (22) aus dem zweiten metallischen Werkstoff umfasst.

13. Halbleiteranordnung (42) mit mindestens einem Halbleiterelement (44) und einem Kühlkörper (2) nach Anspruch 12, wobei das Halbleiterelement (44) elektrisch isolierend und thermisch leitend mit dem Kühlkörper (2) verbunden ist.

14. Halbleiteranordnung (42) nach Anspruch 13,
wobei das mindestens eine Halbleiterelement (44) durch eine Vergussmasse (50) vergossen ist,
wobei die Vergussmasse (50) durch die umlaufende Seitenwand (26) des Kühlkörpers (2) begrenzt ist.

15. Stromrichter (52) mit mindestens einer Halbleiteranordnung (42) nach einem der Ansprüche 13 oder 14.

## Claims

1. Method for producing a heat sink (2) with fins (24) and a peripheral side wall (26) by extrusion, comprising the following steps:
- providing (A) a die (4), which has a base surface (6), and a punch (8), which has a pressure surface (10), wherein the base surface (6) of the die (4) has openings (12), wherein a peripheral rebate (14) is formed on the pressure surface (10) of the punch (8),
- placing (B) a semifinished product (20) made of a first metal material into the die (4),
- releasably connecting (C) a material layer (22) made of a second metal material, which has a higher thermal conductivity than the first metal material, to the pressure surface (10) of the punch (8),
- bringing the punch (8) into contact (D) via the material layer (22) with the semifinished product (20) that is placed in the die (4),
- pressing (E) the first metal material of the semifinished product (20) by means of the punch (8) through the openings (12) of the die (4) so as to form the fins (24) and into the peripheral rebate (14) of the punch (8) so as to form the peripheral side wall (26), wherein the material layer (22) is connected over its entire surface to the first metal material of the semifinished product (20), wherein the heat sink (2) is formed by the pressing (E),
- releasing (F) the punch (8) from the material layer (22),
- ejecting (G) the heat sink (2) from the die (4).

2. Method according to claim 1,
wherein after the pressing (E) the fins (24) are cut to length (H), in particular flush, in the die (4).

3. Method according to one of claims 1 or 2,
wherein the material layer (22) is releasably connected to the punch (8) in such a way that the material layer (22) is flush with the pressure surface (10) of the punch (8).

4. Method according to one of the preceding claims,
wherein the material layer (22) is connected in a material-bonded manner to the first metal material via a pressure welding connection.

5. Method according to one of the preceding claims,
wherein the material layer (22) is roughened on a side facing away from the pressure surface (10) of the punch (8).

6. Method according to claim 5,
wherein the material layer (22) is connected to the first metal material via micro-interlocks.

7. Method according to one of the preceding claims,
wherein the openings (12) of the die (4) are configured as elongated holes (38, 40),
wherein the first metal material of the semifinished product (20) is pressed through the elongated holes (38, 40) of the die (4) so as to form lamellar fins (24).

8. Method according to one of the preceding claims,
wherein a dielectric material layer (36) is releasably connected between the pressure surface (10) of the punch (8) and the material layer (22) made of the second metal material,
wherein the dielectric material layer (36) is non-releasably connected to the material layer (22) during the pressing (E).

9. Method according to one of the preceding claims,
wherein the die (4) has an inner shell surface (16) and the punch (8) has an outer shell surface (18),
wherein during the pressing (E) the outer shell surface (18) of the punch (8) is moved running parallel flush with respect to the inner shell surface (16) of the die (4).

10. Method according to one of the preceding claims,
wherein an aluminium alloy, in particular a wrought aluminium alloy, is used for the first metal material.

11. Method according to claim 10,
wherein an aluminium alloy is used, which contains silicon in a proportion by weight in the range of 0.1% to 1%, in particular in the range of 0.1% to 0.5%.

12. Heat sink (2) for a semiconductor arrangement (42), which is produced by an extrusion process according to one of the preceding claims, having
- fins (24),
which are produced by pressing (E) the semifinished product (20) by means of a pressure surface (10) of the punch (8) through openings (12) of the die (4),
- a peripheral side wall (26),
which is arranged on a side of the heat sink (2) lying opposite the fins (24) and
is produced by pressing (E) the semifinished product (20) into a peripheral rebate (14) of the punch (8),
- a planar surface within the peripheral side wall (26) which is formed by the pressure surface (10) of the punch (8) and comprises the material layer (22) made of the second metal material.

13. Semiconductor arrangement (42) with at least one semiconductor element (44) and a heat sink (2) according to claim 12,
wherein the semiconductor element (44) is connected in an electrically insulating and thermally conductive manner to the heat sink (2).

14. Semiconductor arrangement (42) according to claim 13, wherein the at least one semiconductor element (44) is encapsulated by a casting compound (50),
wherein the casting compound (50) is delimited by the peripheral side wall (26) of the heat sink (2).

15. Power converter (52) with at least one semiconductor arrangement (42) according to one of claims 13 or 14.

## Revendications

1. Procédé de fabrication par filage d'un dissipateur (2) à ailettes (24) et à paroi (26) latérale faisant le tour, comprenant les stades suivants :
- se procurer (A) une matrice (4), qui a une surface (6) de base, et un poinçon (8), qui a une surface (10) d'application d'une pression, dans lequel la surface (6) de base de la matrice (4) a des ouvertures (12), dans lequel il est formé, sur la surface (10) d'application d'une pression du poinçon (8), un pli (14) faisant le tour,
- insérer (B) un produit semi-fini en un premier matériau (20) métallique dans la matrice (4),
- relier (C) de manière amovible une couche (22) de matériau en un deuxième matériau métallique, qui a une conductivité thermique plus grande que le premier matériau métallique, à la surface (10) d'application d'une pression du poinçon (8),
- mettre en contact (D) le poinçon (8) par la couche (22) de matériau avec le produit semi-fini (20) inséré dans la matrice (4),
- presser (E) le premier matériau métallique du produit semi-fini (20), au moyen du poinçon (8), dans les ouvertures (12) de la matrice (4) pour la formation des ailettes (24) et dans le pli (14) faisant le tour du poinçon (8) pour la constitution de la paroi (26) latérale faisant le tour, dans lequel la couche (22) de matériau est reliée sur toute la surface au premier matériau métallique du produit semi-fini (20), dans lequel on forme le dissipateur (2) par la pression (E),
- séparation (F) du poinçon (8) de la couche (22) de matériau,
- expulsion (G) du dissipateur (2) de la matrice (4).

2. Procédé suivant la revendication 1,
dans lequel, après la pression (E) a lieu une mise à longueur (H), en particulier à affleurement, des ailettes (24) dans la matrice (4).

3. Procédé suivant la revendication 1 ou 2,
dans lequel on relie la couche (22) de matériau au poinçon (8) de manière amovible, de manière à ce que la couche (22) de matériau se termine au ras de la surface (10) d'application d'une pression du poinçon (8).

4. Procédé suivant l'une des revendications précédentes,
dans lequel on relie, à coopération de matière, la couche (22) de matériau au premier matériau métallique par un soudage sous pression.

5. Procédé suivant l'une des revendications précédentes,
dans lequel on rend rugueuse la couche (22) de matériau d'un côté, non tourné vers la surface (10) d'application d'une pression du poinçon (8).

6. Procédé suivant la revendication 5,
dans lequel on relie la couche (22) de matériau au premier matériau métallique par de microcomplémentarités de forme.

7. Procédé suivant l'une des revendications précédentes,
dans lequel les ouvertures (12) de la matrice (4) sont constituées de trous (38, 40) oblongs,
dans lequel on presse le premier matériau métallique du produit semi-fini (20) dans les trous (38, 40) oblongs de la matrice (4) pour la constitution d'ailettes (24) en forme de lamelles.

8. Procédé suivant l'une des revendications précédentes,
dans lequel on relie une couche (36) de matériau diélectrique d'une manière amovible entre la couche (10) d'application d'une pression du poinçon (8) et la couche (22) de matériau en le deuxième matériau métallique,
dans lequel on relie la couche (36) de matériau diélectrique lors de l'application (E) d'une pression, de manière non détachable à la couche (22) de matériau.

9. Procédé suivant l'une des revendications précédentes,
dans lequel la matrice (4) a une surface (16) latérale intérieure et le poinçon (8) une surface (18) latérale extérieure,
dans lequel on déplace la surface (18) latérale extérieure du poinçon (8) lors de l'application (E) d'une pression parallèlement et à affleurement avec la surface (16) latérale intérieure de la matrice (4).

10. Procédé suivant l'une des revendications précédentes,
dans lequel on utilise, pour le premier matériau métallique, un alliage d'aluminium, en particulier un alliage forgeable d'aluminium.

11. Procédé suivant la revendication 10,
dans lequel on utilise un alliage d'aluminium, qui contient du silicium en une proportion en poids dans la gamme de 0,1 % à 1 %, en particulier dans la gamme de 0,1 % à 0,5 %.

12. Dissipateur (2) pour un agencement (42) à semiconducteur, qui est fabriqué par un procédé de filage suivant l'une des revendications précédentes, comportant :
- des ailettes (24),
qui sont fabriquées en pressant (E) le produit semi-fini (20) au moyen d'une surface (10) d'application d'une pression du poinçon (8), dans des ouvertures (12) de la matrice (4),
- une paroi (26) latérale faisant le tour,
qui est disposée d'un côté, opposé aux ailettes (24) du dissipateur (2), et
qui est fabriquée par pression (E) du demi-produit (20) dans un pli (14) faisant le tour du poinçon (8),
- une surface plane dans la paroi (26) latérale faisant le tour,
qui est constituée par la surface (10) d'application d'une pression (8) et qui comprend la couche (22) de matériau en le deuxième matériau métallique.

13. Agencement (42) à semiconducteur comprenant au moins un élément (44) à semiconducteur et un dissipateur (2) suivant la revendication 12, dans lequel l'élément (44) à semiconducteur est relié d'une manière isolante électriquement et conductrice thermiquement au dissipateur (2).

14. Agencement (42) à semiconducteur suivant la revendication 13,
dans lequel le au moins un élément (44) à semiconducteur est coulé par une masse (50) de coulée,
dans lequel la masse (50) de coulée est délimitée par la paroi (26) latérale faisant le tour du dissipateur (2).

15. Convertisseur (52) ayant au moins un agencement (42) à semiconducteur suivant l'une des revendications 13 ou 14.
